# EUROPEAN PATENT APPLICATION

(11) **EP 4 521 452 A1**
(43) Date of publication of application: **12.03.2025**
(21) Application number: 24182644.5
(22) Date of filing: 17.06.2024
(51) Int. Cl.: H01L 21/8234, H01L 27/088, H01L 29/08, H01L 29/78

(54) **TRANSISTOR AND SEMICONDUCTOR MEMORY DEVICE INCLUDING THE SAME**

(30) Priority: 07.09.2023 KR 20230118877
(71) Applicant: Samsung Electronics Co., Ltd., Suwon-si, Gyeonggi-do 16677 (KR)
(72) Inventor: LEE, Sea Hoon, 16677 Suwon-si (KR); LIM, Jun Hee, 16677 Suwon-si (KR); OH, Jun Seok, 16677 Suwon-si (KR); CHANG, Seong Pil, 16677 Suwon-si (KR)
(74) Representative: Marks & Clerk LLP

(57) **Abstract**

A transistor that may provide improved durability and reliability is disclosed. The transistor includes a substrate including an active region, an element isolation film in the substrate that defines the active region, a first impurity region on a lower surface of the element isolation film, a second impurity region in the substrate, a gate electrode on the substrate and extending in a first direction, a source/drain area on at least one side of the gate electrode, a first source/drain contact group on the source/drain area, and a second source/drain contact group on the source/drain area and spaced apart from the first source/drain contact group in the first direction, wherein the second impurity region is between the first source/drain contact group and the second source/drain contact group.

## Description

### BACKGROUND

### Technical Field

The present disclosure relates to a transistor and a semiconductor memory including the same. More specifically, the present disclosure relates to a transistor and a 3-dimensional semiconductor memory device including the transistor and memory cells arranged 3-dimensionally.

### Description of the Related Art

To meet high performance and low price of semiconductor memory devices as demanded by consumers, the integration of semiconductor memory devices may be increased. The integration of semiconductor memory devices is an important factor in determining a price thereof. Thus, semiconductor memory devices having increased integration may be particularly required.

Integration of a two-dimensional (2D) or planar semiconductor memory device is largely determined based on an occupancy area of a unit memory cell, and therefore may be greatly affected by a level of a fine pattern formation skill. However, ultra-expensive equipment is typically required for formation of fine patterns. Thus, although the integration of the 2D semiconductor memory device is increasing, the increase thereof may be limited. Accordingly, a three-dimensional semiconductor memory device including three-dimensionally arranged memory cells has been proposed.

### SUMMARY

The present disclosure describes a transistor that may have improved durability and reliability.

The present disclosure describes a semiconductor memory device including a transistor that may have improved durability and reliability.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means illustrated in the claims and combinations thereof.

According to an aspect of the present disclosure, there is provided a transistor comprising a substrate including an active region, an element isolation film in the substrate that defines the active region, a first impurity region on a lower surface of the element isolation film, a second impurity region in the substrate, a gate electrode on the substrate and extending in a first direction, a source/drain area on at least one side of the gate electrode, a first source/drain contact group on the source/drain area, and a second source/drain contact group on the source/drain area and spaced apart from the first source/drain contact group in the first direction, wherein the second impurity region is between the first source/drain contact group and the second source/drain contact group.

According to another aspect of the present disclosure, there is provided a transistor comprising a substrate including an active region, a gate electrode on the substrate and extending in a first direction, an element isolation film in the substrate that defines the active region, a first impurity region on a lower surface of the element isolation film, a second impurity region in the substrate and extending in a second direction intersecting the first direction, a source/drain area on at least one side of the gate electrode, a first source/drain contact group on the source/drain area, and a second source/drain contact group on the source/drain area and spaced apart from the first source/drain contact group in the first direction, wherein the source/drain area includes, a third impurity region in contact with the first source/drain contact group, and a fourth impurity region between the third impurity region and the gate electrode, wherein a concentration of N-type impurities in the third impurity region is greater than a concentration of N-type impurities in the fourth impurity region, wherein the second impurity region does not overlap with the first source/drain contact group in a third direction perpendicular to an upper surface of the substrate.

According to still another aspect of the present disclosure, there is provided a semiconductor memory device comprising a peripheral circuit structure including a transistor, and a cell structure on the peripheral circuit structure, wherein the cell structure includes a cell substrate, a mold structure including a plurality of cell gate electrodes sequentially stacked on the cell substrate, and a channel structure extending through the plurality of cell gate electrodes, wherein the transistor includes a substrate including an active region, an element isolation film in the substrate that defines the active region, a first impurity region on a lower surface of the element isolation film, a second impurity region in the substrate, a gate electrode on the substrate and extending in a first direction, a source/drain area on at least one side of the gate electrode, a first source/drain contact group on the source/drain area, and a second source/drain contact group on the source/drain area and spaced apart from the first source/drain contact group in the first direction, wherein the second impurity region is between the first source/drain contact group and the second source/drain contact group.

At least some of the above and other features of the invention are set out in the claims.

### BRIEF DESCRIPTION OF DRAWINGS

The above and other aspects and features of the present disclosure will become more apparent by describing in detail embodiments thereof with reference to the attached drawings, in which:
FIG. 1 is a plan view layout diagram that illustrates a transistor according to some embodiments;
FIG. 2 is a cross-sectional view cut along a line A-A in FIG. 1;
FIG. 3 is a cross-sectional view cut along a line B-B in FIG. 1;
FIG. 4 is a plan view layout diagram that illustrates a transistor according to some embodiments;
FIG. 5 is a cross-sectional view that illustrates a transistor according to some embodiments;
FIG. 6 is a cross-sectional view that illustrates a transistor according to some embodiments;
FIG. 7 is a plan view layout diagram that illustrates a transistor according to some embodiments;
FIG. 8 is a cross-sectional view that illustrates the transistor of Fig. 7;
FIG. 9 is a plan view layout diagram that illustrates a transistor according to some embodiments;
FIG. 10 is a block diagram that illustrates a semiconductor memory device according to some embodiments;
FIG. 11 is a circuit diagram that illustrates a semiconductor memory device according to some embodiments;
FIG. 12 is a diagram that illustrates a semiconductor memory device according to some embodiments;
FIG. 13 is an enlarged view that illustrates an R1 area in FIG. 12;
FIG. 14 is a diagram that illustrates a semiconductor memory device according to some embodiments;
FIG. 15 is a diagram that illustrates a semiconductor memory device according to some embodiments;
FIG. 16 is a block diagram that illustrates an electronic system according to some embodiments;
FIG. 17 is a perspective view that illustrates an electronic system according to some embodiments;
FIG. 18 is a schematic cross-sectional view taken along a line I-I of FIG. 17.

### DETAILED DESCRIPTION

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may include within the scope of the present disclosure as defined by the appended claims.

A shape, a size, a ratio, an angle, a number, etc. disclosed in the drawings for illustrating embodiments of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is for the purpose of describing particular embodiments only and is not intended to limit the present disclosure. As used herein, the singular forms "a" and "an" are intended to include the plural forms as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of" when preceding a list of elements may modify the entirety of list of elements and may not modify the individual elements of the list. When referring to "C to D", this means C inclusive to D inclusive unless otherwise specified.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

In addition, it will also be understood that when a first element or layer is referred to as being present "on" or "beneath" a second element or layer, the first element may be disposed directly on or beneath the second element or may be disposed indirectly on or beneath the second element with a third element or layer being disposed between and connected to the first and second elements or layers. It will be understood that when an element or layer is referred to as being "connected to", or "coupled to" another element or layer, it may be directly on, connected to, or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present. Furthermore, "between" may mean that one element is located between other elements when views from a particular perspective, for example, an element may be "between" two elements when viewed in plan view, but may be located above or below the elements when viewed in a side view or cross section.

Further, as used herein, when a layer, film, region, plate, or the like may be disposed "on" or "on a top" of another layer, film, region, plate, or the like, the former may directly contact the latter or still another layer, film, region, plate, or the like may be disposed between and connected to the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between and connected to the former and the latter. Further, as used herein, when a layer, film, region, plate, or the like may be disposed "below" or "under" another layer, film, region, plate, or the like, the former may directly contact the latter or still another layer, film, region, plate, or the like may be disposed between and connected to the former and the latter. As used herein, when a layer, film, region, plate, or the like is directly disposed "below" or "under" another layer, film, region, plate, or the like, the former directly contacts the latter and still another layer, film, region, plate, or the like is not disposed between and connected to the former and the latter.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In one example, when a certain embodiment may be implemented differently, a function or operation specified in a specific block may occur in a sequence different from that specified in a flowchart. For example, two consecutive blocks may be actually executed at the same time. Depending on a related function or operation, the blocks may be executed in a reverse sequence. It is intended that all embodiments disclosed herein can be implemented separately or combined in any way and/or combination. Aspects described with respect to one embodiment may be incorporated in different embodiments although not specifically described relative thereto. That is, all embodiments and/or features of any embodiments can be combined in any way and/or combination.

In descriptions of temporal relationships, for example, temporal precedent relationships between two events such as "after", "subsequent to", "before", etc., another event may occur therebetween unless "directly after", "directly subsequent" or "directly before" is not indicated. The features of the various embodiments of the present disclosure may be partially or entirely combined with each other, and may be technically associated with each other or operate with each other. The embodiments may be implemented independently of each other and may be implemented together in an association relationship.

Spatially relative terms, such as "beneath," "below," "lower," "under," "above," "upper," and the like, may be used herein for ease of explanation for illustrating one element or feature's relationship to another element or feature as illustrated in the figures. It will be understood that the spatially relative terms are intended to encompass different orientations of the device in use or in operation, in addition to the orientation depicted in the figures. For example, when the device in the drawings may be turned over, elements described as "below" or "beneath" or "under" other elements or features would then be oriented "above" the other elements or features. Thus, the example terms "below" and "under" may encompass both an orientation of above and below. The device may be otherwise oriented, for example, rotated 90 degrees or at other orientations, and the spatially relative descriptors used herein should be interpreted accordingly.

Terms as used herein "first direction Y", "second direction X" and "third direction Z" should not be interpreted only to have a geometric relationship in which the first direction, the second direction, and the third direction are perpendicular to each other. The "first direction Y", "second direction X" and "third direction Z" may be interpreted to have a broader direction within a range in which components herein may work functionally.

Hereinafter, embodiments of the present disclosure will be described in detail with reference to the accompanying drawings. The same reference numerals are used for the same components in the drawings, and duplicate descriptions thereof are omitted.

In drawings relating to a transistor according to some embodiments, an example in which the transistor includes a channel area of a planar shape is shown. However, the present disclosure is not limited thereto. The transistor according to some embodiments may include a fin-shaped transistor (FinFET) including a channel area of a fin-shaped pattern shape, a transistor including a nanowire or nanosheet, and an MBCFET^{™} (Multi-Bridge Channel Field Effect Transistor). Furthermore, the semiconductor device according to some embodiments may include a tunneling transistor (a tunneling FET), or a 3-dimensional (3D) transistor. In addition, the technical idea of the present disclosure may be applied to a transistor based on a 2D material (2D material based FETs) and a heterostructure thereof.

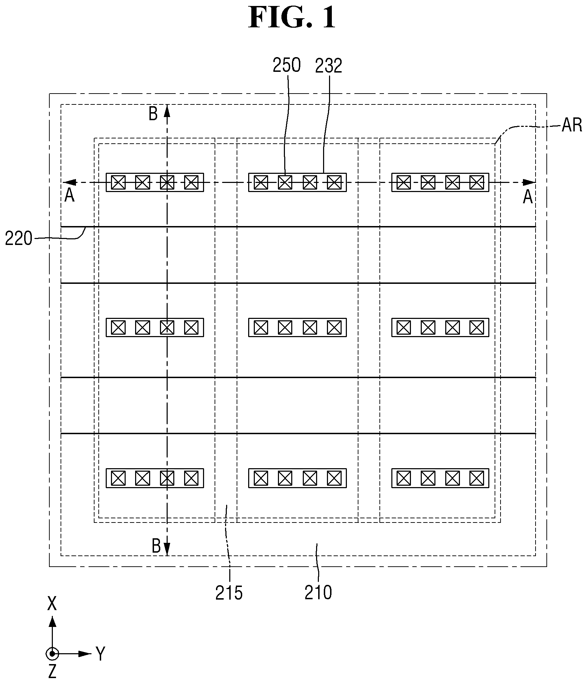

Hereinafter, with reference to FIGS. 1 to FIG. 9, a transistor according to some embodiments is described.

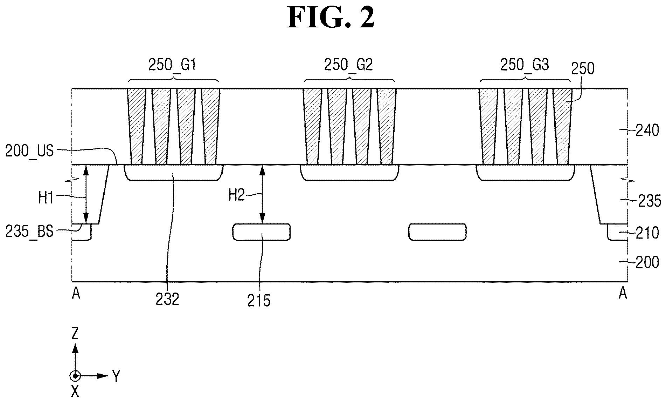

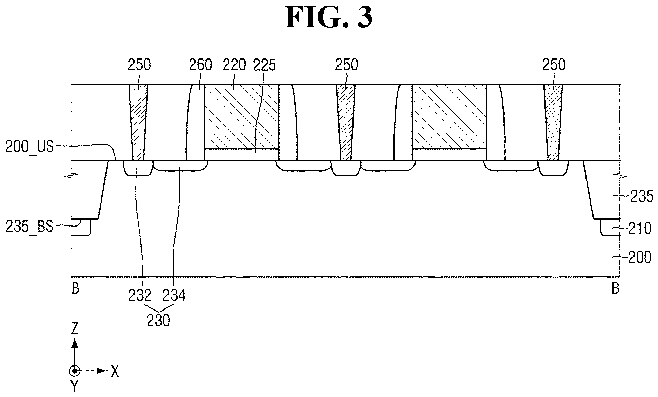

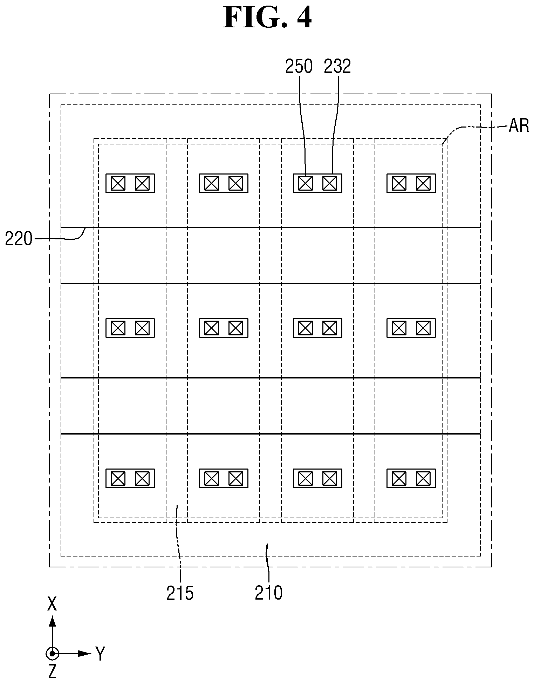

FIG. 1 is a plan view layout diagram that illustrates a transistor according to some embodiments. FIG. 2 is a cross-sectional view cut along a line A-A in FIG. 1. FIG. 3 is a cross-sectional view cut along a line B-B in FIG. 1. FIG. 4 is a layout diagram that illustrates a transistor according to some embodiments.

Referring to FIG. 1 to FIG. 4, the transistor according to some embodiments may include a substrate 200, a first impurity region 210, a second impurity region 215, a gate electrode 220, a gate insulating film 225, a source/drain area 230, and a source/drain contact 250, etc.

The substrate 200 may be made of a semiconductor material or may include a semiconductor material. The substrate 200 may be a silicon substrate or a SOI (silicon-on-insulator) substrate. In other embodiments, the substrate 200 may include, but is not limited to, silicon germanium, SGOI (silicon germanium on insulator), indium antimonide, lead telluride compound, indium arsenide, indium phosphide, gallium arsenide, and/or gallium antimonide.

The active region AR may be disposed on the substrate. The active region AR may be defined by an element isolation film 235. In one example, the active region AR may be an area where NMOS is formed. In another example, the active region AR may be an area where PMOS is formed.

The element isolation film 235 is disposed in the substrate 200. In other embodiments, the element isolation film 235 may be formed on the substrate 200 to define the active region AR. The element isolation film 235 may be in and at least partially fill an element isolation trench. The element isolation film 235 may have a shallow trench isolation (STI) structure having excellent element isolation ability and a small footprint, thus being advantageous in terms of high integration. However, embodiments of the present disclosure are not limited thereto. For example, the element isolation film 235 may include at least one of silicon oxide, silicon nitride, silicon oxynitride, and combinations thereof.

The first impurity region 210 may be disposed in the substrate 200. The first impurity region 210 is formed on a lower surface 235_BS of the element isolation film 235. A boundary surface between the first impurity region 210 and the element isolation film 235 may be a bottom surface of the element isolation trench. The first impurity region 210 may surround the active region AR in the plan view of FIG. 1.

The second impurity region 215 is disposed in the substrate 200. The second impurity region 215 may extend in the second direction X. The second impurity region 215 may be at least partially surrounded with the substrate 200. In other words, the second impurity region 215 is disposed in the substrate 200.

The second impurity region 215 may be disposed between a first source/drain contact group 250_G1 and a second source/drain contact group 250_G2, which will be described below, and between the second source/drain contact group 250_G2 and a third source/drain contact group 250_G3 which will be described below in a plan view. The second impurity region 215 may be not overlapping with the first to third source/drain contact groups 250_G1, 250_G2, and 250_G3 in the third direction Z. In other words, when viewed in plan view, the second impurity region 215 may be not overlapping with one or more of the source/ drain contact groups. In an embodiment there is no overlap between the second impurity region 215 and any of the source drain contact groups.

The first impurity region 210 may have a first vertical (i.e., third direction Z) dimension H1 up to (distance from) the upper surface 200_US of substrate 200. In this regard, a first vertical dimension H1 may be a distance from a top surface of the first impurity region 210 to the upper surface 200_US of the substrate 200.

The second impurity region 215 may be spaced from the upper surface 200_US of substrate 200 by a second vertical dimension H2. In this regard, the second vertical dimension H2 may be a distance from a top surface of the second impurity region 215 to the upper surface 200_US of substrate 200. The first vertical dimension H1 and the second vertical dimension H2 may be equal to each other.

The first impurity region 210 and the second impurity region 215 may contain dopants of the same conductivity type. In one example, the dopant may include a P-type impurity. The P-type impurity may be, for example, one of boron (B) or gallium (Ga). However, embodiments of the present disclosure are not limited thereto. In another example, the dopant may include an N-type impurity. For example, the N-type impurity may include phosphorus (P), arsenic (As), antimony (Sb), and/or bismuth (Bi). In following descriptions, an example in which the dopant includes the P-type impurity is described.

The gate electrode 220 may be disposed on the substrate 200 and the active region AR. The gate electrode 220 may extend in the first direction Y. The gate electrode 220 may overlap the second impurity region 215 disposed in the substrate 200 in the third direction Z.

The gate electrode 220 may include a metal, a metal alloy, a conductive metal nitride, a metal silicide, a doped semiconductor material, a conductive metal oxide, and/or a conductive metal oxynitride. The gate electrode 220 may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V) and combinations thereof. Embodiments of the present disclosure, however, are not limited thereto. The conductive metal oxide and the conductive metal oxynitride may include oxidized products of the above-mentioned materials. Embodiments of the present disclosure are not limited thereto.

The gate electrode 220 is shown as a single film. However, embodiments of the present disclosure are not limited thereto. For example, the gate electrode 220 may have a stack structure of multiple films respectively made of the conductive metal materials as described above or combinations thereof.

The gate insulating film 225 may be disposed on the upper surface 200_US of the substrate 200. The gate insulating film 225 may be disposed between the substrate 200 and the gate electrode 220.

The gate insulating film 225 is shown as a single film. However, embodiments of the present disclosure are not limited thereto. The gate insulating film 225 may include an interface insulating film and a high dielectric constant insulating film.

The gate insulating film 225 may include silicon oxide, silicon oxynitride, silicon nitride, or a high dielectric constant material with a higher dielectric constant than that of silicon oxide. The high dielectric constant (high-k) material may include for example, boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate.

A gate spacer 260 may be disposed on the substrate 200. The gate spacer 260 may be disposed on a sidewall of the gate insulating film 225 and a sidewall of the gate electrode 220. The gate spacer 260 is shown as having a bar shape. However, embodiments of the present disclosure are not limited thereto. For example, a shape of the gate spacer 260 may have an L-shape.

The gate spacer 160 may include, for example, silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof. Embodiments of the present disclosure, however, are not limited thereto. Although it is illustrated that the gate spacer 160 is embodied as a single film, this is intended only for convenience of illustration, and embodiments of the present disclosure are not limited thereto.

The source/drain area 230 may be disposed on (or in) the substrate 200. The source/drain area 230 may be disposed at at least on one side of the gate electrode 220, when viewed in plan view. The source/drain area 230 may be disposed at each of both opposing sides of the gate electrode 220.

The source/drain area 230 may include a third impurity region 232 and a fourth impurity region 234.

The third impurity regions 232 may be arranged to be spaced apart from each other in the first direction Y and/ or the second direction X. The third impurity region 232 may be disposed in a corresponding manner to the source/drain contact 250, which will be described below. That is, the third impurity region 232 may be disposed to overlap the source/drain contact 250 in the third direction Z. The third impurity region 232 may not overlap with the second impurity region 215 in the third direction Z.

The third impurity region 232 may be in contact with source/drain contact 250, which will be described below. A depth of the third impurity region 232 may be greater than a depth of the fourth impurity region 234 into the substrate 200 from an upper surface 200_US thereof. The third impurity regions 232 and the fourth impurity regions 234 may be aligned with each other in the second direction X. The fourth impurity region 234 may be formed at each of both opposing sides of the gate electrode 220. The fourth impurity region 234 is shown to overlap with the gate spacer 260 in the third direction Z. However, embodiments of the present disclosure are not limited thereto. For example, the fourth impurity region 234 may not overlap with the gate spacer 260 in the third direction Z.

The third impurity region 232 and the fourth impurity region 234 may include impurities of the same conductivity type. A concentration of the impurity in the third impurity region 232 may be greater than a concentration of the impurity in the fourth impurity region 234.

The source/drain contact 250 may be disposed on the source/drain area 230. The source/drain contact 250 may contact the third impurity region 232. The source/drain contact 250 may be disposed on each of both opposing sides of the gate electrode 220. The source/drain contacts 250 may be arranged in the second direction X.

The source/drain contacts 250 may be grouped into the first source/drain contact group 250_G1, the second source/drain contact group 250_G2, and the third source/drain contact group 250_G3.

The first source/drain contact group 250_G1, the second source/drain contact group 250_G2, and the third source/drain contact group 250_G3 may include the same number of source/drain contacts 250. For example, the number of source/drain contacts 250 in each of the first source/drain contact group 250_G1, the second source/drain contact group 250_G2, and the third source/drain contact group 250_G3 may be four.

The first source/drain contact group 250_G1, the second source/drain contact group 250_G2, and the third source/drain contact group 250_G3 may be aligned with each other in the first direction Y. Specifically, the first source/drain contact group 250_G1 and the second source/drain contact group 250_G2 are spaced apart from each other in the first direction Y. The second source/drain contact group 250_G2 and the third source/drain contact group 250_G3 may be spaced from each other in the first direction Y. A distance between the first source/drain contact group 250_G1 and the second source/drain contact group 250_G2 may be equal to a distance between the second source/drain contact group 250_G2 and the third source/drain contact group 250_G3.

It is illustrated that each of the first to third source/drain contact group 250_G1, 250_G2, and 250_G3 includes the four source/drain contacts. However, embodiments of the present disclosure are not limited thereto. For example, as shown in FIG. 4, the number of source/drain contacts 250 may be two. In another example, the number of source/drain contacts may be 3, or 5 or larger.

The source/drain contact 250 may include a conductive material, for example, metal, metal nitride, metal carbonitride, a two-dimensional (2D) material, and/or a conductive semiconductor material.

A first inter-wiring insulating film 240 may be formed on the upper surface 200_US of the substrate 200. The first inter-wiring insulating film 240 may include an insulating material. The first inter-wiring insulating film 240 may be on and at least partially cover the element isolation film 235, the gate electrode 220, and the source/drain contact 250.

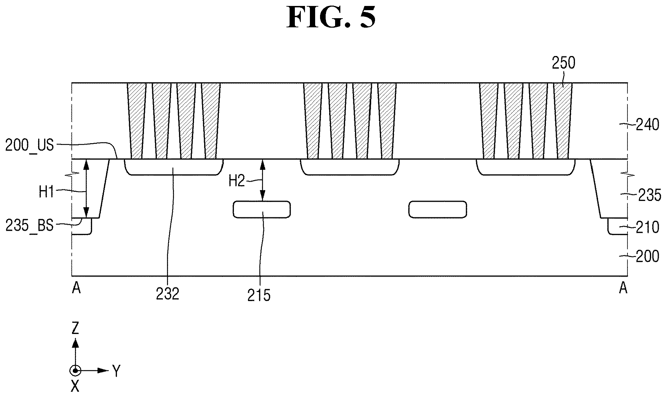

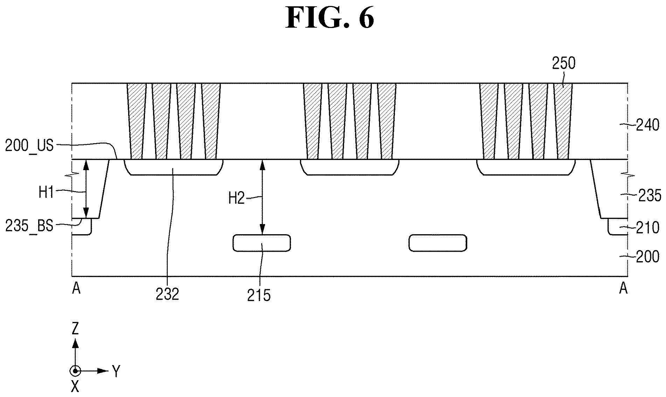

FIG. 5 is a cross-sectional view that illustrates a transistor according to some embodiments. FIG. 6 is a cross-sectional view that illustrates a transistor according to some embodiments. For convenience of description, the following descriptions are based on differences thereof from those as described in FIG. 1 to FIG. 4.

Referring to FIG. 5 and FIG. 6, the first impurity region 210 may have the first vertical dimension H1 up to the upper surface 200_US of substrate 200. In this regard, the first vertical dimension H1 may be the distance from the top surface of the first impurity region 210 to the upper surface 200_US of the substrate 200.

The second impurity region 215 may be spaced from the upper surface 200_US of substrate 200 by the second vertical dimension H2. In this regard, the second vertical dimension H2 may be the distance from the top surface of the second impurity region 215 to the upper surface 200_US of substrate 200.

In one example, as shown in FIG. 5, the first vertical dimension H1 may be larger than the second vertical dimension H2. In another example, as shown in FIG. 6, the first vertical dimension H1 may be smaller than the second vertical dimension H2.

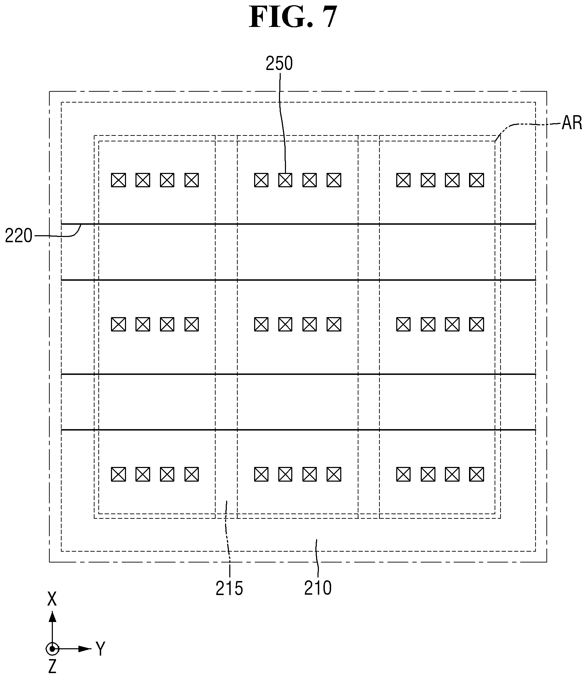

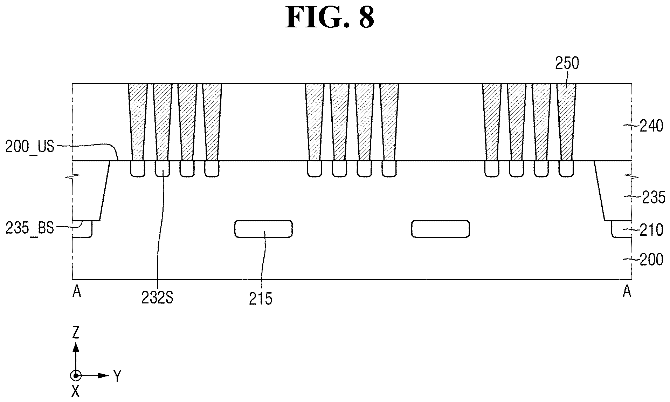

FIG. 7 and FIG. 8 are drawings that illustrate a transistor according to some embodiments. For convenience of description, the following descriptions are based on differences thereof from those as described in FIG. 1 to FIG. 4.

Referring to FIG. 7 and FIG. 8, the third impurity region 232 may include sub-impurity regions 232S.

The third impurity region 232 in FIG. 2 may be divided into the induvial sub-impurity regions 232S in a corresponding manner to the source/drain contacts 250. Except for this difference, the description of the sub-impurity region 232S may be substantially the same as the description of the third impurity region 232 in FIG. 2.

Specifically, the sub-impurity region 232S may be in contact with the source/drain contact 250. The sub-impurity region 232S may overlap the source/drain contact 250 in the third direction Z. The sub-impurity regions 232S may be arranged in the first direction Y. The sub-impurity regions 232S may be spaced from each other in the first direction Y.

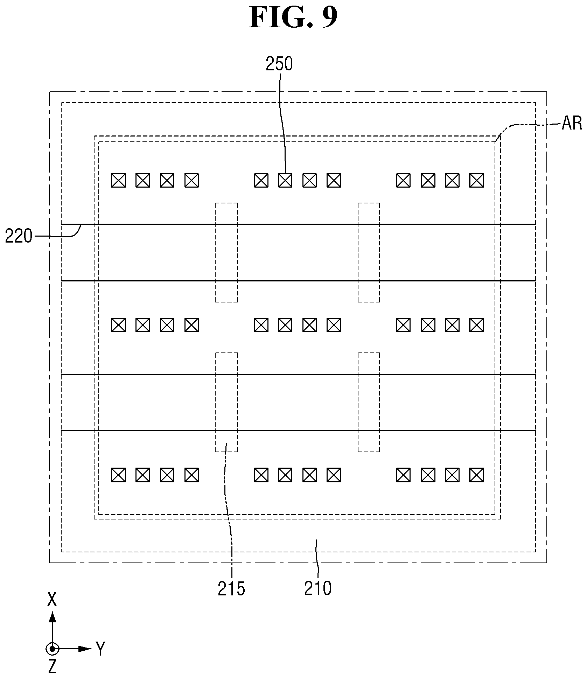

FIG. 9 is a plan view layout diagram that illustrates a transistor according to some embodiments. For convenience of description, the following descriptions are based on differences thereof from those as described in FIG. 1 to FIG. 4 and FIG. 8.

Referring to FIG. 9, the second impurity region 215 may be disposed in the substrate 200. The second impurity region 215 may be at least partially surrounded with the substrate 200. The second impurity region 215 may be not overlapping with the source/drain contact groups 250_G1, 250_G2, and 250_G3 in the first direction Y and in the third direction Z.

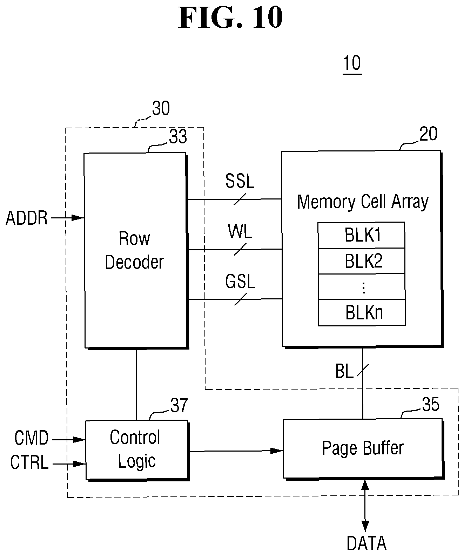

Hereinafter, with reference to FIG. 10 to FIG. 15, a semiconductor memory device including a transistor according to some embodiments is described.

FIG. 10 is a block diagram that illustrates a semiconductor memory device according to some embodiments.

Referring to FIG. 10, a semiconductor memory device 10 according to some embodiments includes a memory cell array 20 and a peripheral circuit 30.

The memory cell array 20 may include a plurality of memory cell blocks (BLK1 to BLKn). Each of the memory cell blocks BLK1 to BLKn may include a plurality of memory cells. The memory cell array 20 may be connected to the peripheral circuit 30 via a bit-line BL, a word line WL, at least one string select line SSL, and at least one ground select line GSL. Specifically, the memory cell blocks BLK1 to BLKn may be connected to a row decoder 33 via the word line WL, the string select line SSL, and the ground select line GSL. Further, the memory cell blocks BLK1 to BLKn may be connected to a page buffer 35 via the bit-line BL.

The peripheral circuit 30 may receive an address ADDR, a command CMD, and a control signal CTRL from an external device to the semiconductor memory device 10, and may transmit and receive data to and from an external device and the semiconductor memory device 10. The peripheral circuit 30 may include a control logic 37, the row decoder 33, and the page buffer 35. Although not shown, the peripheral circuit 30 may further include various sub-circuits, such as an input/output circuit, a voltage generation circuit for generating various voltages required for an operation of the semiconductor memory device 10, and an error correction circuit for correcting an error of the data DATA read from the memory cell array 20.

The control logic 37 may be connected to the row decoder 33, the input/output circuit, and the voltage generation circuit. The control logic 37 may control overall operations of the semiconductor memory device 10. The control logic 37 may generate various internal control signals used in the semiconductor memory device 10 in response to the control signal CTRL. For example, the control logic 37 may adjust a voltage level of a voltage supplied to the word line WL and the bit-line BL when performing a memory operation, such as a program operation or an erase operation.

The row decoder 33 may select at least one of the plurality of memory cell blocks BLK1 to BLKn in response to the address ADDR, and may select at least one word line WL, at least one string select line SSL, and at least one ground select line GSL of the selected at least one memory cell block BLK1 to BLKn. Further, the row decoder 33 may transmit a voltage for performing a memory operation to the word line WL of the selected at least one memory cell block BLK1 to BLKn.

The page buffer 35 may be connected to the memory cell array 20 via the bit-line BL. The page buffer 35 may operate as a writer driver or a sense amplifier. Specifically, when performing a program operation, the page buffer 35 operates as the writer driver to apply a voltage based on the data DATA to be stored in the memory cell array 20 to the bit-line BL. On the other hand, when performing a read operation, the page buffer 35 may operate as the sense amplifier to detect the data DATA stored in the memory cell array 20.

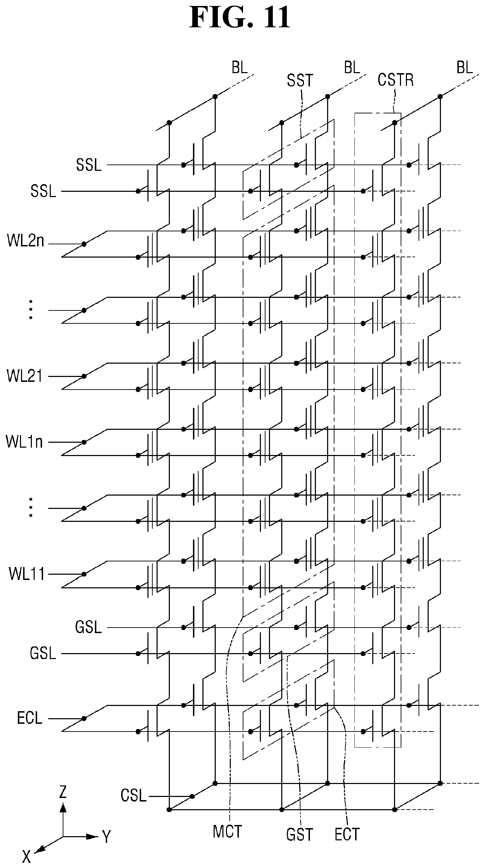

FIG. 11 is a circuit diagram that illustrates a semiconductor memory device according to some embodiments.

Referring to FIG. 11, a memory cell array (e.g., 20 in FIG. 10) of a semiconductor memory device according to some embodiments includes a common source line CSL, a plurality of bit-lines BL, and a plurality of cell strings CSTR.

The common source line CSL may extend in the first direction X. In some embodiments, a plurality of common source lines CSL may be arranged in a two-dimensional manner. For example, the plurality of common source lines CSL may be spaced apart from each other and extend in the first direction X. The same voltage may be applied to the common source lines CSL. In other embodiments, different voltages may be individually applied to be the common source lines CSL.

The plurality of bit-lines BL may be arranged in a two-dimensional manner. For example, the bit-lines BL may be spaced apart from each other and extend in the second direction Y intersecting the first direction X. The plurality of cell strings CSTR may be connected in parallel to each of the bit-lines BL. The cell strings CSTR may be connected to the common source line CSL. That is, the plurality of cell strings CSTR may be disposed between the bit-lines BL and the common source line CSL.

Each of the cell strings CSTR may include a ground select transistor GST connected to the common source line CSL, a string select transistor SST connected to the bit-line BL, and a plurality of memory cell transistors MCT disposed between the ground select transistor GST and the string select transistor SST. Each of the memory cell transistors MCT may include a data storage element. The ground select transistor GST, the string select transistor SST and the memory cell transistors MCT may be connected in series to each other.

The common source line CSL may be commonly connected to sources of the ground select transistors GST. Further, a ground select line GSL, a plurality of word lines WL1 1 to WL1n and WL21 to WL2n and a string select line SSL may be disposed between the common source line CSL and the bit-line BL. The ground select line GSL may act as a gate electrode of the ground select transistor GST. The word lines WL11 to WL1n and WL21 to WL2n may be respectively used as gate electrodes of the memory cell transistors MCT. The string select line SSL may act as a cell gate electrode of the string select transistor SST.

In some embodiments, an erase control transistor ECT may be disposed between the common source line CSL and the ground select transistor GST. The common source line CSL may be commonly connected to sources of the erase control transistors ECT. Further, an erase control line ECL may be disposed between the common source line CSL and the ground select line GSL. The erase control line ECL may act as a cell gate electrode of the erase control transistor ECT. The erase control transistors ECT may generate gate induced drain leakage (GIDL) to execute an erase operation of the memory cell array.

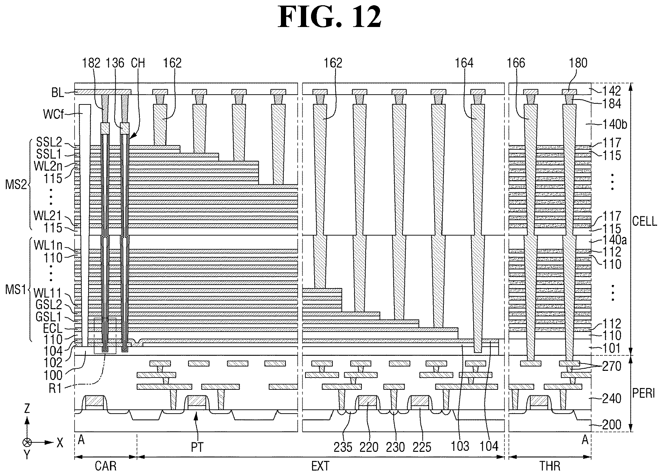

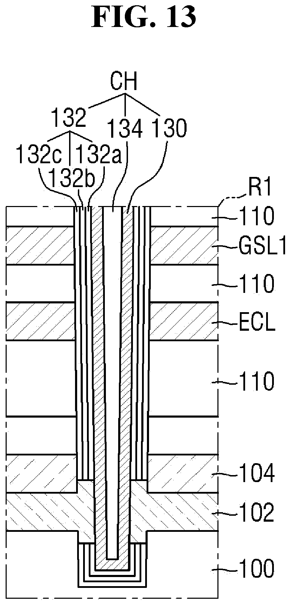

FIG. 12 is a diagram that illustrates a semiconductor memory device according to some embodiments. FIG. 13 is an enlarged view for illustrating a R1 area in FIG. 12.

Referring to FIG. 12 to FIG. 13, a semiconductor memory device according to some embodiments includes a memory cell area CELL and a peripheral circuit area PERI. The memory cell area CELL may be stacked on the peripheral circuit area PERI.

The memory cell area CELL may include a cell substrate 100, an insulating substrate 101, a mold structure MS1 and MS2, an interlayer insulating film 140a and 140b, a channel structure CH, a channel pad 136, a bit-line BL, a cell contact 162, a source contact 164, a through-via 166 and a first wiring structure 180.

The cell substrate 100 may include, for example, a semiconductor substrate, such as a silicon substrate, a germanium substrate, or a silicon-germanium substrate. In other embodiments, the cell substrate 100 may include a silicon-on-insulator (SOI) substrate or a germanium-on-insulator (GOI) substrate. In some embodiments, the cell substrate 100 may include impurities. For example, the cell substrate 100 may include n-type impurities (e.g., phosphorus (P), arsenic (As), etc.).

The cell substrate 100 may include a cell array area CAR and an extension area EXT.

The memory cell array (e.g., 20 in FIG. 10) including the plurality of memory cells may be formed in the cell array area CAR. For example, the channel structure CH, the bit-line BL, and the cell gate electrodes ECL, GSL1, GSL2, WL11 to WL1n, WL21 to WL2n, SSL1 and SSL2, etc. to be described below may be disposed in the cell array area CAR. In a following description, a surface of the cell substrate 100 on which the memory cell array is disposed may be referred to as a front surface of the cell substrate 100. A surface of the cell substrate 100 opposite to the front surface of the cell substrate 100 may be referred to as a back surface of the cell substrate 100.

The extension area EXT may be disposed around the cell array area CAR. The gate electrodes ECL, GSL1, GSL2, WL11 to WL1n, WL21 to WL2n, SSL1 and SSL2 to be described below may be disposed in the extension area EXT and may be stacked in a step manner.

In some embodiments, the cell substrate 100 may further include a through-area THR. The through-area THR may be disposed in the cell array area CAR and the extension area EXT, or may be disposed outside the cell array area CAR and the extension area EXT. A through-via 166 to be described later may be disposed in the through-area THR.

The insulating substrate 101 may be formed in the cell substrate 100 and in the extension area EXT. The insulating substrate 101 may constitute an insulating area in the cell substrate 100 and in the extension area EXT. The insulating substrate 101 may include, for example, silicon oxide, silicon nitride, silicon oxynitride, and/or silicon carbide. However, embodiments of the present disclosure are not limited thereto. In some embodiments, the insulating substrate 101 may be formed in the cell substrate 100 and in the through-area THR.

A lower surface of the insulating substrate 101 is only shown to be coplanar with a lower surface of the cell substrate 100. However, this is only an example. In another example, a vertical level, i.e., third direction Z level, of the lower surface of the insulating substrate 101 may be lower than that of the lower surface of the cell substrate 100.

The mold structure MS1 and MS2 may be formed on the front surface of the cell substrate 100. The mold structure MS1 and MS2 may include the plurality of cell gate electrodes ECL, GSL1, GSL2, WL11 to WL1n, WL21 to WL2n, SSL1 and SSL2 and a plurality of mold insulating films 110 and 115 stacked on the cell substrate 100. Each of the cell gate electrodes ECL, GSL1, GSL2, WL11 to WL1n, WL21 to WL2n, SSL1 and SSL2 and each of the mold insulating films 110 and 115 may have a layered structure extending in a parallel manner to the front surface of the cell substrate 100. The cell gate electrodes ECL, GSL1, GSL2, WL11 to WL1n, WL21 to WL2n, SSL1 and SSL2 may be sequentially stacked on the cell substrate 100 while being spaced apart from each other via each of the mold insulating films 110 and 115.

In some embodiments, the mold structure MS1 and MS2 may include the first mold structure MS 1 and the second mold structure MS2 that are sequentially stacked on the cell substrate 100.

The first mold structure MS1 may include first cell gate electrodes ECL, GSL1, GSL2, and WL11 to WL1n and the first mold insulating films 110 alternately stacked on the cell substrate 100. In some embodiments, the first cell gate electrodes ECL, GSL1, GSL2, and WL1 1 to WL1n may include the erase control line ECL, the ground select line GSL1 and GSL2, and a plurality of first word lines WL11 to WL1n sequentially stacked on the cell substrate 100. The ground select line GSL1 and GSL2 may include the first ground select line GSL1 and the second ground select line GSL2 which are sequentially stacked. It is shown that the first cell gate electrodes ECL, GSL1, GSL2, and WL11 to WL1n includes two ground select lines GSL1 and GSL2. This is just an example, and the first cell gate electrodes ECL, GSL1, GSL2, and WL11 to WL1n may include three or more ground select lines. In some other embodiments, the erase control line ECL may be omitted.

The second mold structure MS2 may include second cell gate electrodes WL21 to WL2n, SSL1, and SSL2, and the second mold insulating film 115, which are alternately stacked on top of each other and are disposed on the first mold structure MS1. In some embodiments, the second cell gate electrodes WL21 to WL2n, SSL1, and SSL2 may include a plurality of second word lines WL21 to WL2n and the string select line SSL1 and SSL2, which are sequentially stacked on the first mold structure MS1. The string select line SSL1 and SSL2 may include the first string select line SSL1 and the second string select line SSL2, which are sequentially stacked. It is shown that the second cell gate electrodes WL21 to WL2n, SSL1, and SSL2 include only two string select lines SSL1 and SSL2. This is just an example, and the second cell gate electrodes WL21 to WL2n, SSL1, and SSL2 may include three or more string select lines.

Each of the cell gate electrodes ECL, GSL1, GSL2, WL11 to WL1n, WL21 to WL2n, SSL1, and SSL2 may be made of a conductive material, for example, a metal, such as tungsten (W), cobalt (Co), and/or nickel (Ni) or a semiconductor material, such as silicon. However, embodiments of the present disclosure are not limited thereto.

Each of the mold insulating films 110 and 115 may include an insulating material, for example, silicon oxide, silicon nitride, and/or silicon oxynitride. However, embodiments of the present disclosure are not limited thereto.

In some embodiments, the mold structure MS1 and MS2 in the through-area THR may include a plurality of mold sacrificial films 112 and 117 and a plurality of mold insulating films 110 and 115 alternately stacked on the cell substrate 100 and/or the insulating substrate 101. Each of the mold sacrificial films 112 and 117 and each of the mold insulating films 110 and 115 may have a layered structure extending in a parallel manner to the upper surface of the cell substrate 100. The mold sacrificial films 112 and 117 may be sequentially stacked on the cell substrate 100 while being spaced apart from each other via each of the mold insulating films 110 and 115.

In some embodiments, the first mold structure MS1 in the through-area THR may include the first mold sacrificial films 112 and the first mold insulating films 110 alternately stacked on the cell substrate 100. The second mold structure MS2 in the through-area THR may include the second mold sacrificial films 117 and the second mold insulating films 115 that are alternately stacked on the first mold structure MS1.

Each of the mold sacrificial films 112 and 117 may include an insulating material, for example, silicon oxide, silicon nitride, and/or silicon oxynitride. However, embodiments of the present disclosure are not limited thereto. In some embodiments, each of the mold sacrificial films 112 and 117 may include a material having an etch selectivity with respect to that of each of the mold insulating films 110 and 115. In one example, each of the mold insulating films 110 and 115 may include silicon oxide, and each of the mold sacrificial films 112 and 117 may include silicon nitride.

The interlayer insulating films 140a and 140b may be formed on the cell substrate 100 to be on and at least partially cover the mold structure MS1 and MS2. In some embodiments, the interlayer insulating films 140a and 140b may include the first interlayer insulating film 140a and the second interlayer insulating film 140b sequentially stacked on the cell substrate 100. The first interlayer insulating film 140a may be on and at least partially cover the first mold structure MS1, and the second interlayer insulating film 140b may be on and at least partially cover the second mold structure MS2. The interlayer insulating film 140a and 140b may include, for example, at least one of silicon oxide, silicon oxynitride, and a low-k material having a dielectric constant lower than that of the silicon oxide. However, embodiments of the present disclosure are not limited thereto.

The channel structure CH may be formed in the cell array area CAR and in the mold structure MS1 and MS2. The channel structure CH may extend in a vertical direction (hereinafter, the third direction Z) intersecting the upper surface of the cell substrate 100 and may extend through the mold structure MS1 and MS2. For example, the channel structure CH may have a pillar shape (e.g., cylindrical shape) extending in the third direction Z. Accordingly, the channel structure CH may intersect each of the cell gate electrodes ECL, GSL1, GSL2, WL11 to WL1n, WL21 to WL2n, SSL1 and SSL2. In some embodiments, the channel structure CH may have a stepped portion between the first mold structure MS1 and the second mold structure MS2.

The channel structure CH may include a semiconductor pattern 130 and an information storage film 132.

The semiconductor pattern 130 may extend in the third direction Z and may extend through the mold structure MS 1 and MS2. Although the semiconductor pattern 130 is illustrated only in a shape of a cup, this is only an example. In another example, the semiconductor pattern 130 may have various shapes, such as a cylindrical shape, a rectangular cylindrical shape, and a solid pillar shape. The semiconductor pattern 130 may include, for example, a semiconductor material, such as single crystal silicon, polycrystalline silicon, an organic semiconductor material, and a carbon nano structure. However, embodiments of the present disclosure are not limited thereto.

The information storage film 132 may be interposed between the semiconductor pattern 130 and each of the cell gate electrodes ECL, GSL1, GSL2, WL11 to WL1n, WL21 to WL2n, SSL1 and SSL2. For example, the information storage film 132 may extend along and on an outer face of the semiconductor pattern 130. The information storage film 132 may include, for example, silicon oxide, silicon nitride, silicon oxynitride, and/or a high dielectric constant material having a dielectric constant greater than that of silicon oxide. The high dielectric constant material may include, for example, aluminum oxide, hafnium oxide, lanthanum oxide, tantalum oxide, titanium oxide, lanthanum hafnium oxide, lanthanum aluminum oxide, dysprosium scandium oxide, and combinations thereof.

In some embodiments, the information storage film 132 may be composed of a multilayer. For example, the information storage film 132 may include a tunnel insulating film 132a, a charge storage film 132b, and a blocking insulating film 132c that are sequentially stacked on an outer face of the semiconductor pattern 130.

The tunnel insulating film 132a may include, for example, silicon oxide or a high dielectric constant material (e.g., aluminum oxide (Al₂O₃), hafnium oxide (HfO₂)) having a dielectric constant higher than that of silicon oxide. The charge storage film 132b may include, for example, silicon nitride. The blocking insulating film 132c may include, for example, silicon oxide or a high dielectric constant material (e.g., aluminum oxide (Al₂O₃), hafnium oxide (HfO₂)) having a dielectric constant higher than that of silicon oxide.

In some embodiments, the channel structure CH may further include a filling pattern 134. The filling pattern 134 may be formed to at least partially fill an inside of the cup-shaped semiconductor pattern 130. The filling pattern 134 may include an insulating material, for example, silicon oxide. However, embodiments of the present disclosure are not limited thereto.

In some embodiments, the channel structure CH may further include a channel pad 136. The channel pad 136 may be formed to be connected to a top of the semiconductor pattern 130. The channel pad 136 may include, for example, polysilicon doped with impurities. However, embodiments of the present disclosure are not limited thereto.

In some embodiments, the plurality of channel structures CH may be arranged in a zigzag manner. For example, the plurality of channel structures CH may be arranged in a zigzag manner in the first direction Y and the second direction X parallel to the upper surface of the cell substrate 100. The plurality of channel structures CH arranged in the zigzag manner may further improve integration density of the semiconductor memory device. In some embodiments, the plurality of channel structures CH may be arranged in a honeycomb manner.

In some embodiments, a dummy channel structure DCH may be formed in the mold structure MS1 and MS2 and in the extension area EXT. The dummy channel structure DCH may be formed in a similar shape to that of the channel structure CH to reduce the stress applied to the mold structure MS1 and MS2 in the extension area EXT.

In some embodiments, a first source structure 102 and 104 may be formed on the cell substrate 100. The first source structure 102 and 104 may be interposed between the cell substrate 100 and the mold structure MS 1 and MS2. For example, the first source structure 102 and 104 may extend along the upper surface of the cell substrate 100. The first source structure 102 and 104 may be formed to contact the semiconductor pattern 130 of the channel structure CH. For example, the first source structure 102 and 104 may extend through the information storage film 132 to contact the semiconductor pattern 130. The first source structure 102 and 104 may be provided as a common source line (for example, CSL in FIG. 11) of the semiconductor memory device. The first source structure 102 and 104 may include, for example, impurity-doped polysilicon or metal. However, embodiments of the present disclosure are not limited thereto.

In some embodiments, the channel structure CH may extend through the first source structure 102 and 104. For example, a lower end of the channel structure CH may extend through the first source structure 102 and 104 to be disposed within the cell substrate 100.

In some embodiments, the first source structure 102 and 104 may be formed as a stack of multilayers. For example, the first source structure 102 and 104 may include the first source layer 102 and the second source layer 104, which are sequentially stacked on the cell substrate 100. Each of the first source layer 102 and the second source layer 104 may include impurity-doped polysilicon or non-impurity-doped polysilicon. However, embodiments of the present disclosure are not limited thereto. The first source layer 102 may be in contact with the semiconductor pattern 130 to serve as a common source line (for example, CSL in FIG. 11) of the semiconductor memory device. The second source layer 104 may be used as a support layer to reduce the likelihood of or prevent the mold stack from collapsing or falling down in a replacement process to form the first source layer 102.

Although not shown, a base insulating film may be interposed between the cell substrate 100 and the first source structure 102 and 104. For example, the base insulating film may include silicon oxide, silicon nitride, and/or silicon oxynitride, but is not limited thereto.

In some embodiments, the first source structure 102 and 104 may be not formed in a portion of the extension area EXT where the insulating substrate 101 is formed. An upper surface of the insulating substrate 101 is shown to be coplanar with an upper surface of the first source structure 102 and 104. This is just an example. In another example, a vertical level, i.e., third direction Z level, of the upper surface of the insulating substrate 101 may be higher than that of the upper surface of the first source structure 102 and 104.

In some embodiments, a source sacrificial film 103 may be formed on a portion of the cell substrate 100. For example, the source sacrificial film 103 may be formed on a portion of the cell substrate 100 in the extension area EXT. The source sacrificial film 103 may include a material having an etch selectivity with respect to that of each of the mold insulating films 110 and 115. In one example, each of the mold insulating films 110 and 115 may include silicon oxide, and the source sacrificial film 103 may include silicon nitride. The source sacrificial film 103 may be a layer remaining after a portion thereof has been replaced with the first source layer 102 during a manufacturing process of the first source structure 102 and 104.

Each of a block isolation area WCf, a first partial isolation area WC1, and a second partial isolation area WC2 may extend in the first direction X to cut the mold structure MS1 and MS2. The block isolation area WCf may cut an entirety of the mold structure MS1 and MS2. For example, the block isolation area WCf may extend continuously in the first direction X. Each of the first partial isolation area WC1 and the second partial isolation area WC2 may cut a portion of the mold structure MS1 and MS2. For example, the first partial isolation areas WC1 arranged in a first row along the first direction X may be spaced apart from each other and thus may partially cut the mold structure MS1 and MS2. The second partial isolation areas WC2 arranged in a first row along the first direction X may be spaced apart from each other and thus may partially cut the mold structure MS1 and MS2.

The bit-line BL may be formed on the mold structure MS1 and MS2. The bit-line BL may extend in the second direction Y to intersect the block isolation area WCf. Furthermore, the bit-line BL may extend in the second direction Y to contact the plurality of channel structures CH arranged along the second direction Y. For example, a bit-line contact 182 contacting a top of each of the channel structures CH may be formed in the second interlayer insulating film 140b. The bit-line BL may be electrically connected to the channel structures CH via the bit-line contact 182.

The cell contact 162 may contact each of the cell gate electrodes ECL, GSL1, GSL2, WL11 to WL1n, WL21 to WL2n, SSL1, and SSL2. For example, the cell contact 162 may extend in the third direction Z and in the interlayer insulating film 140a and 140b to contact each of the cell gate electrodes ECL, GSL1, GSL2, WL11 to WL1n, WL21 to WL2n, SSL1, and SSL2. In some embodiments, the cell contact 162 may have a stepped portion between the first mold structure MS1 and the second mold structure MS2.

The source contact 164 may contact the first source structure 102 and 104. For example, the source contact 164 may extend in the third direction Z and in the interlayer insulating film 140a and 140b to contact the cell substrate 100. In some embodiments, the source contact 164 may have a stepped portion between the first mold structure MS1 and the second mold structure MS2.

The through-via 166 may be disposed in the through-area THR. For example, the through-via 166 may extend in the third direction Z while being disposed in the mold structure MS1 and MS2 and in the through-area THR. In some embodiments, the through-via 166 may have a stepped portion between the first mold structure MS1 and the second mold structure MS2. It is shown only that the through-via 166 extends through the mold structure MS 1 and MS2. This is just an example. In another example, the through-via 166 may be disposed out of the mold structure MS1 and MS2 and may not extend through the mold structure MS1 and MS2.

Each of the cell contact 162, the source contact 164, and the through-via 166 may contact the first wiring structure 180 disposed on the interlayer insulating film 140a and 140b. For example, a second wiring insulating film 142 may be formed on the second interlayer insulating film 140b. The first wiring structure 180 may be formed in the second wiring insulating film 142. Each of the cell contact 162, the source contact 164, and the through-via 166 may be connected to the first wiring structure 180 via a contact via 184. Although not specifically shown, the first wiring structure 180 may be connected to the bit-line BL.

The peripheral circuit area PERI may include the substrate 200, a peripheral circuit element PT, and a second wiring structure 270.

The peripheral circuit element PT may be formed on the substrate 200. The peripheral circuit element PT may constitute the peripheral circuit (e.g., 30 in FIG. 10) that controls an operation of the semiconductor memory device. For example, the peripheral circuit element PT may include the control logic (e.g., 37 in FIG. 10), the row decoder (e.g., 33 in FIG. 10), and the page buffer (e.g., 35 in FIG. 10). In a following description, a surface of the substrate 200 on which the peripheral circuit element PT is disposed may be referred to as a front surface of the substrate 200. On the other hand, a surface of the substrate 200 opposite to the front surface of the substrate 200 may be referred to as a back surface of the substrate 200.

The peripheral circuit element PT may include, for example, the transistor as described above with reference to FIG. 1 to FIG. 9. However, embodiments of the present disclosure are not limited thereto. For example, the peripheral circuit element PT may include various active elements as well as various passive elements, such as capacitors, resistors, and inductors, in addition to the transistor as described above with reference to FIG. 1 to FIG. 9

In some embodiments, the back surface of the cell substrate 100 may face the front surface of the substrate 200. For example, a first inter-wiring insulating film 240 on and at least partially covering the peripheral circuit element PT may be formed on the front surface of the substrate 200. The cell substrate 100 and/or the insulating substrate 101 may be stacked on an upper surface of the first inter-wiring insulating film 240.

The first wiring structure 180 may contact the peripheral circuit element PT via the through-via 166. For example, the second wiring structure 270 contacting the peripheral circuit element PT may be formed in the first inter-wiring insulating film 240. The through-via 166 may extend in the third direction Z to connect the first wiring structure 180 and the second wiring structure 270 to each other. Accordingly, the bit-line BL, each of the cell gate electrodes ECL, GSL1, GSL2, WL11 to WL1n, WL21 to WL2n, SSL1, and SSL2, and/or the first source structure 102 and 104 may be electrically connected to the peripheral circuit element PT.

In some embodiments, the through-via 166 may extend through the insulating substrate 101 to connect the first wiring structure 180 and the second wiring structure 270 to each other. Thus, the through-via 166 may be electrically insulated from the cell substrate 100.

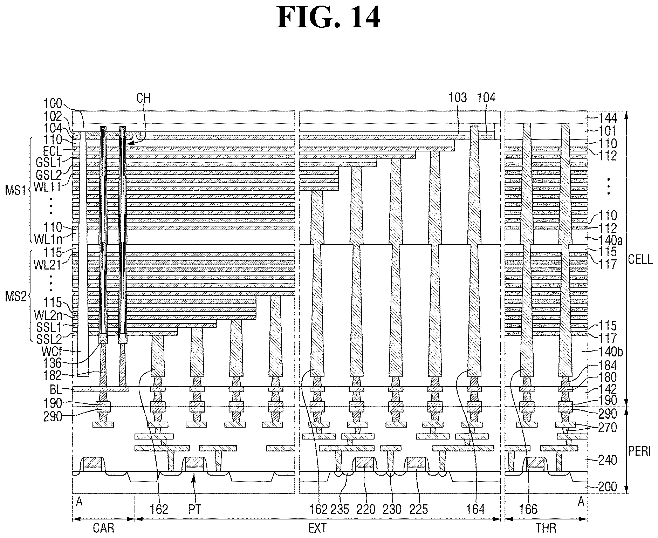

FIG. 14 is a diagram that illustrates a semiconductor memory device according to some embodiments. For convenience of description, the following descriptions are based on differences thereof from those as described in FIG. 10 to FIG. 13.

Referring to FIG. 14, in a semiconductor memory device according to some embodiments, the front surface of the cell substrate 100 faces the front surface of the substrate 200.

For example, the semiconductor memory device according to some embodiments may have a chip to chip (C2C) structure. The C2C structure may refer to a structure in which an upper chip including the memory cell area CELL is disposed on a first wafer (e.g., the cell substrate 100), and a lower chip including the peripheral circuit area PERI is disposed on a second wafer (e.g., the substrate 200) different from the first wafer, and then the upper chip and the lower chip are connected to each other in a bonding scheme.

In one example, the bonding scheme means a scheme for electrically connecting a first bonding metal 190 formed in an uppermost metal layer of the upper chip and a second bonding metal 290 formed in an uppermost metal layer of the lower chip to each other. For example, when each of the first bonding metal 190 and the second bonding metal 290 is made of copper (Cu), the bonding scheme may be embodied as a Cu-Cu bonding scheme. However, this is merely an example. In another example, each of the first bonding metal 190 and the second bonding metal 290 may be made of various other metals, such as aluminum (Al) or tungsten (W).

As the first bonding metal 190 and the second bonding metal 290 are bonded to each other, the first wiring structure 180 may be connected to the second wiring structure 270. Thus, the bit-line BL, each of the cell gate electrodes ECL, GSL1, GSL2, WL11 to WL1n, WL21 to WL2n, SSL1, and SSL2 and/or the first source structure 102 and 104 may be electrically connected to the peripheral circuit element PT.

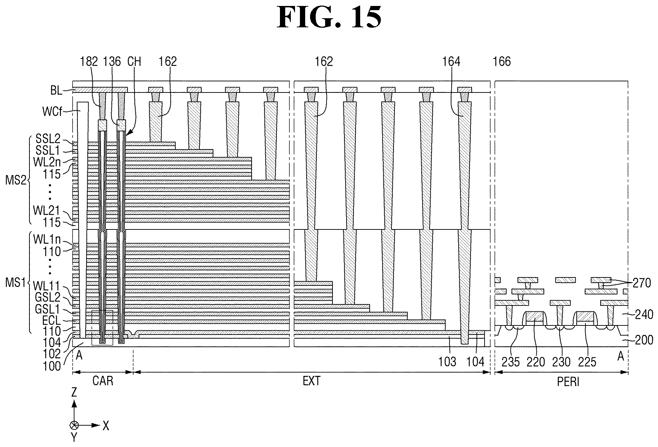

FIG. 15 is a diagram that illustrates a semiconductor memory device according to some embodiments. For convenience of description, the following descriptions are based on differences thereof from those as described in FIG. 10 to FIG. 13.

Referring to FIG. 15, a semiconductor memory device according to some embodiments includes a memory cell area CELL and a peripheral circuit area PERI.

Unlike what is shown in FIG. 12, the peripheral circuit area PERI may be disposed around the cell area CELL. The peripheral circuit area PERI may include the peripheral circuit element PT. Although not shown, a through-via may be disposed on the peripheral circuit area PERI. The peripheral circuit element PT may be electrically connected to the bit-line BL, each of the cell gate electrodes ECL, GSL1, GSL2, WL11 to WL1n, WL21 to WL2n, SSL1, SSL2 and/or the first source structure 102 and 104 via the through-via.

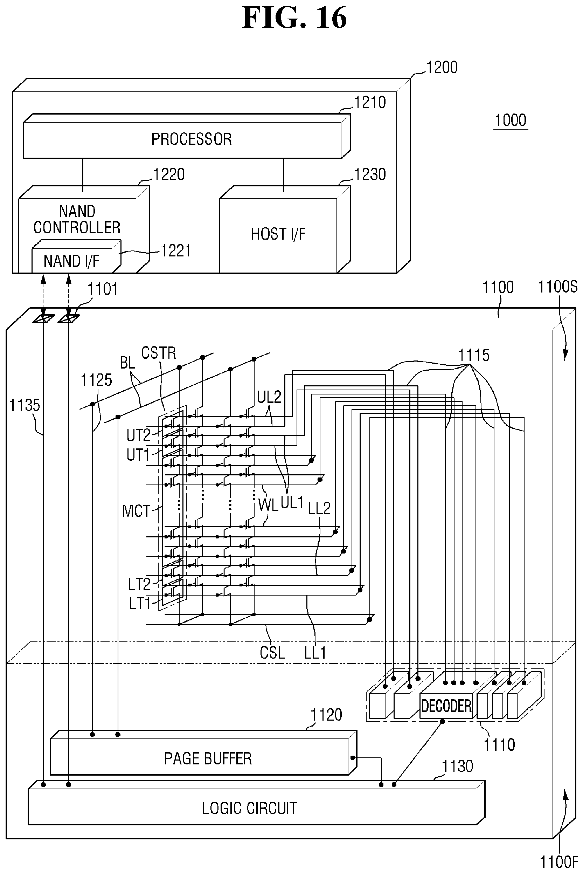

Hereinafter, an electronic system including a semiconductor memory device according to illustrative embodiments will be described with reference to FIG. 16 to FIG. 18.

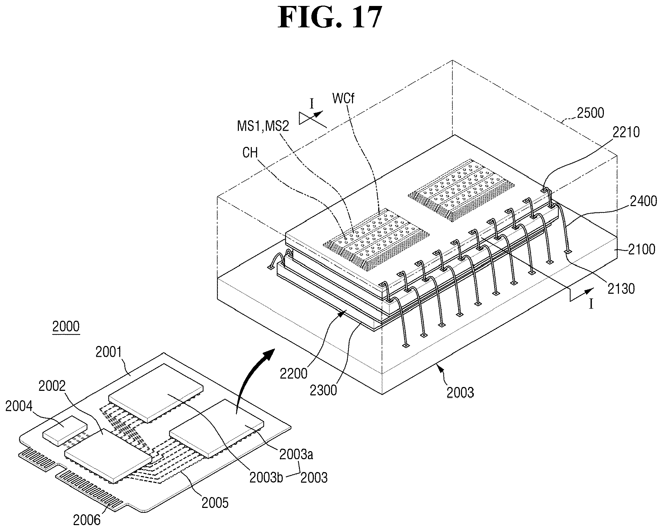

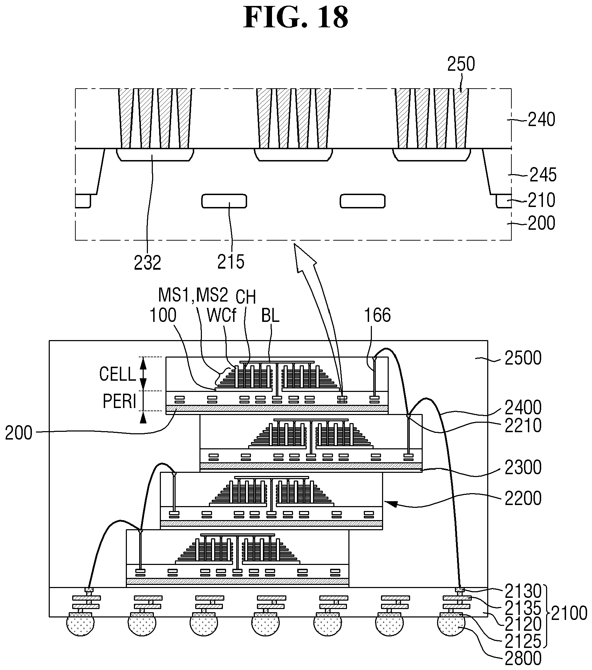

FIG. 16 is a block diagram that illustrates an electronic system according to some embodiments. FIG. 17 is a perspective view that illustrates an electronic system according to some embodiments. FIG. 18 is a schematic cross-sectional view taken along a line I-I of FIG. 17.

Referring to FIG. 16, an electronic system 1000 according to some embodiments may include a semiconductor memory device 1100 and a controller 1200 electrically connected to the semiconductor memory device 1100. The electronic system 1000 may be a storage device including one or a plurality of semiconductor memory devices 1100 or an electronic device including the storage device. For example, the electronic system 1000 may be embodied as a solid state drive device (SSD), a Universal Serial Bus (USB), a computing system, a medical device, or a communication device including one or a plurality of semiconductor memory devices 1100.

The semiconductor memory device 1100 may be embodied, for example, as a nonvolatile memory device (e.g., a NAND flash memory device) and may include, for example, the semiconductor memory device as described above with reference to FIGS. 10 to 15. The semiconductor memory device 1100 may include a first structure 1100F and a second structure 1100S on the first structure 1100F.

The first structure 1100F may be a peripheral circuit structure including a decoder circuit 1110 (for example, the row decoder 33 in FIG. 10), the page buffer 1120 (for example, the page buffer 35 in FIG. 10), and a logic circuit 1130 (for example, the control logic 37 of FIG. 10).

The second structure 1100S may include the common source line CSL, the plurality of bit-lines BL, and the plurality of cell strings CSTR as described above with reference to FIG. 2. The cell strings CSTR may be connected to the decoder circuit 1110 via the word line WL, at least one string select line SSL, and at least one ground select line GSL. Further, the cell strings CSTR may be connected to the page buffer 1120 via the bit-lines BL.

In some embodiments, the common source line CSL and the cell strings CSTR may be electrically connected to the decoder circuit 1110 via first connection lines 1115 extending from the first structure 1100F to the second structure 1100S. The first connection line 1115 may correspond to the through-via 166 as described above using FIGS. 10 to 15. That is, the through-via 166 may electrically connect each of the cell gate electrodes ECL, GSL1, GSL2, WL, and SSL and the decoder circuit 1110 (e.g., the row decoder 33 in FIG. 10) to each other.

In some embodiments, the bit-lines BL may be electrically connected to the page buffer 1120 via second connection lines 1125 extending from the first structure 1100F to the second structure 1100S. The second connection line 1125 may correspond to the through-via 166 as described above using FIGS. 10 to 15. That is, the through-via 166 may electrically connect the bit lines BL and the page buffer 1120 (e.g., the page buffer 35 in FIG. 10) to each other.

The semiconductor memory device 1100 may communicate with the controller 1200 via an input/output pad 1101 electrically connected to the logic circuit 1130 (e.g., the control logic 37 in FIG. 10). The input/output pad 1101 may be electrically connected to the logic circuit 1130 via an input/output connection line 1135 extending from the first structure 1100F to the second structure 1100S.

The controller 1200 may include a processor 1210, a NAND controller 1220, and a host interface 1230. In some embodiments, the electronic system 1000 may include a plurality of semiconductor memory devices 1100. In this case, the controller 1200 may control the plurality of semiconductor memory devices 1100.

The processor 1210 may control overall operations of the electronic system 1000 including the controller 1200. The processor 1210 may operate based on predefined firmware, and may control the NAND controller 1220 to access the semiconductor memory device 1100. The NAND controller 1220 may include a NAND interface 1221 that processes communication with the semiconductor memory device 1100. Via the NAND interface 1221, a control command for controlling the semiconductor memory device 1100, data to be written to memory cell transistors MCT of the semiconductor memory device 1100, and data to be read from the memory cell transistors MCT of the semiconductor memory device 1100 may be transmitted. The host interface 1230 may provide a communication function between the electronic system 1000 and an external host. Upon receiving a control command from an external host via the host interface 1230, the processor 1210 may control the semiconductor memory device 1100 in response to the control command.

Referring to FIG. 17 to FIG. 18, an electronic system according to some embodiments may include a main substrate 2001, a main controller 2002 mounted on the main substrate 2001, at least one semiconductor package 2003, and at least one DRAM 2004. The semiconductor package 2003 and he DRAM 2004 may be connected to the main controller 2002 via wiring patterns 2005 formed on the main substrate 2001.

The main substrate 2001 may include a connector 2006 including a plurality of pins coupled to an external host. The number and an arrangement of the plurality of pins in the connector 2006 may vary based on a communication interface between the electronic system 2000 and the external host. In some embodiments, the electronic system 2000 may communicate with the external host using an interface, such as USB (Universal Serial Bus), PCI-Express (Peripheral Component Interconnect Express), SATA (Serial Advanced Technology Attachment), M-Phy for UFS (Universal Flash Storage), etc. In some embodiments, the electronic system 2000 may operate using power supplied from the external host via the connector 2006. The electronic system 2000 may further include a power management integrated circuit (PMIC) for distributing power supplied from the external host to the main controller 2002 and the semiconductor package 2003.

The main controller 2002 may write data to the semiconductor package 2003 or read data from the semiconductor package 2003, and may improve an operating speed of the electronic system 2000.

The DRAM 2004 may act as a buffer memory for reducing a difference between operation speeds of the semiconductor package 2003 as a data storage space and the external host. The DRAM 2004 included in electronic system 2000 may operate as a cache memory, and may provide a space for temporarily storing data therein in a control operation of the semiconductor package 2003. When the DRAM 2004 is included in the electronic system 2000, the main controller 2002 may further include a DRAM controller for controlling the DRAM 2004 in addition to a NAND controller for controlling the semiconductor package 2003.

The semiconductor package 2003 may include a first semiconductor package 2003a and a second semiconductor package 2003b spaced apart from each other. Each of the first semiconductor package 2003a and the second semiconductor package 2003b may be embodied as a semiconductor package including a plurality of semiconductor chips 2200. Each of the first semiconductor package 2003a and the second semiconductor package 2003b may include a package substrate 2100, semiconductor chips 2200 on the package substrate 2100, adhesive layers 2300 disposed on a lower surface of each of the semiconductor chips 2200, a connection structure 2400 electrically connecting the semiconductor chips 2200 and the package substrate 2100 to each other, and a molding layer 2500 disposed the package substrate 2100 and at least partially covering the semiconductor chips 2200 and the connection structure 2400.

The package substrate 2100 may be embodied as a printed circuit board including package upper pads 2130. Each semiconductor chip 2200 may include an input/output pad 2210. The input/output pad 2210 may correspond to the input/output pad 1101 in FIG. 16.

In some embodiments, the connection structure 2400 may be embodied as a bonding wire that electrically connects the input/output pad 2210 and the package upper pads 2130 to each other. Accordingly, in each of the first semiconductor package 2003a and the second semiconductor package 2003b, the semiconductor chips 2200 may be electrically connected to each other in a bonding wire scheme, and may be electrically connected to the package upper pads 2130 of the package substrate 2100. In some embodiments, in each of the first semiconductor package 2003a and the second semiconductor package 2003b, the semiconductor chips 2200 may be electrically connected to each other via a connection structure including a through electrode (Through Silicon Via: TSV) instead of the connection structure 2400 using the bonding wire scheme.

In some embodiments, the main controller 2002 and the semiconductor chips 2200 may be included in one package. In some embodiments, the main controller 2002 and the semiconductor chips 2200 may be mounted on a separate interposer substrate different from the main substrate 2001, and the main controller 2002 and the semiconductor chips 2200 may be connected to each other via a wiring formed in the interposer substrate.

In some embodiments, the package substrate 2100 may be embodied as a printed circuit board. The package substrate 2100 may include a package substrate body 2120, the package upper pads 2130 disposed on a upper surface of the package substrate body 2120, package lower pads 2125 disposed on a lower surface of the package substrate body 2120, or exposed through the lower surface thereof, and internal lines 2135 disposed in the package substrate body 2120 so as to electrically connect the upper pads 2130 and the lower pads 2125 to each other. The upper pads 2130 may be electrically connected to the connection structures 2400. The lower pads 2125 may be connected to the wiring patterns 2005 of the main substrate 2001 of the electronic system 2000 via conductive connectors 2800 as shown in FIG. 18.

In the electronic system according to some embodiments, each of the semiconductor chips 2200 may include the semiconductor memory device as described above using FIG. 10 to FIG. 15. For example, each of the semiconductor chips 2200 may include the peripheral circuit area PERI and the memory cell area CELL stacked on the peripheral circuit area PERI. In an example, the peripheral circuit area PERI may include the transistor as described above using FIGS. 1 to 9. Furthermore, in an example, the memory cell area CELL may include the cell substrate 100, the mold structure MS1 and MS2, and the channel structure CH as described above using FIG. 10 to FIG. 15.

Although embodiments of the present disclosure have been described with reference to the accompanying drawings, the present disclosure is not limited to the above embodiments, but may be implemented in various different forms. A person skilled in the art may appreciate that the present disclosure may be practiced in other concrete forms without departing from the scope of the invention as defined by the claims. Therefore, it should be appreciated that the embodiments as described above are not restrictive but illustrative in all respects.

In concluding the detailed description, those skilled in the art will appreciate that many variations and modifications may be made to the example embodiments without substantially departing from the principles of the present inventive concept. Therefore, the disclosed example embodiments of the invention are used in a generic and descriptive sense only and not for purposes of limitation.
Embodiments are set out in the following clauses:
Clause 1. A transistor comprising: a substrate including an active region; an element isolation film disposed in the substrate so as to define the active region; a first impurity region disposed on a lower surface of the element isolation film; a second impurity region disposed in the substrate; a gate electrode disposed on the substrate and extending in a first direction; a source/drain area disposed on at least one side of the gate electrode; a first source/drain contact group disposed on the source/drain area; and a second source/drain contact group disposed on the source/drain area and spaced apart from the first source/drain contact group in the first direction, wherein the second impurity region is disposed between the first source/drain contact group and the second source/drain contact group.
Clause 2. The transistor of clause 1, wherein the second impurity region is disposed in the substrate and extends in a second direction intersecting the first direction.
Clause 3. The transistor of clause 1 or 2, wherein the first impurity region and the second impurity region contain dopants of a same conductivity type.
Clause 4. The transistor of clause 1, 2, or 3, wherein a number of source/drain contacts of the first source/drain contact group is equal to a number of source/drain contacts of the second source/drain contact group.
Clause 5. The transistor of any one preceding clause, wherein a spacing between the first impurity region and an upper surface of the substrate is different from a spacing between the second impurity region and the upper surface of the substrate.
Clause 6. The transistor of any one preceding clause, wherein a spacing between the first impurity region and an upper surface of the substrate is equal to a spacing between the second impurity region and the upper surface of the substrate.
Clause 7. The transistor of any one preceding clause, wherein each of the first impurity region and the second impurity region contains a P-type dopant.
Clause 8. The transistor of any one preceding clause, wherein the source/drain area includes: a third impurity region in contact with the first source/drain contact group; and a fourth impurity region disposed between the third impurity region and the gate electrode, wherein a concentration of N-type impurities in the third impurity region is greater than a concentration of N-type impurities in the fourth impurity region.
Clause 9. The transistor of clause 8, wherein the first source/drain contact group includes a plurality of first source/drain contacts,
   wherein the third impurity region includes a plurality of sub-impurity regions respectively overlapping the plurality of first source/drain contacts in a third direction that is perpendicular to an upper surface of the substrate.
Clause 10. The transistor of any one preceding clause, further comprising a third source/drain contact group disposed on the source/drain area and spaced apart from the second source/drain contact group in the first direction, wherein a spacing in the first direction between the first source/drain contact group and the second source/drain contact group is equal to a spacing in the first direction between the second source/drain contact group and the third source/drain contact group.
Clause 11. A transistor comprising: a substrate including an active region; a gate electrode disposed on the substrate and extending in a first direction; an element isolation film disposed in the substrate so as to define the active region; a first impurity region disposed on a lower surface of the element isolation film; a second impurity region disposed in the substrate and extending in a second direction intersecting the first direction; a source/drain area disposed on at least one side of the gate electrode; a first source/drain contact group disposed on the source/drain area; and a second source/drain contact group disposed on the source/drain area and spaced apart from the first source/drain contact group in the first direction, wherein the source/drain area includes: a third impurity region in contact with the first source/drain contact group; and a fourth impurity region disposed between the third impurity region and the gate electrode, wherein a concentration of N-type impurities in the third impurity region is greater than a concentration of N-type impurities in the fourth impurity region, wherein the second impurity region does not overlap with the first source/drain contact group in a third direction perpendicular to an upper surface of the substrate.
Clause 12. The transistor of clause 11, wherein the second impurity region is disposed between the first source/drain contact group and the second source/drain contact group.
Clause 13. The transistor of clause 11 or 12, wherein the first impurity region and the second impurity region contain dopants of a same conductivity type.
Clause 14. The transistor of clause 11, 12 or 13wherein the second impurity region does not overlap with the first source/drain contact group in the first direction.
Clause 15. The transistor of any one of clauses 11 to 14, wherein the substrate surrounds the second impurity region in a plan view of the transistor.

## Claims

1. A transistor comprising:
a substrate including an active region;
an element isolation film in the substrate that defines the active region;
a first impurity region on a lower surface of the element isolation film;
a second impurity region in the substrate;
a gate electrode on the substrate and extending in a first direction;
a source/drain area on at least one side of the gate electrode;
a first source/drain contact group on the source/drain area; and
a second source/drain contact group on the source/drain area and spaced apart from the first source/drain contact group in the first direction,
wherein the second impurity region is between the first source/drain contact group and the second source/drain contact group.

2. The transistor of claim 1, wherein the second impurity region is in the substrate and extends in a second direction intersecting the first direction.

3. The transistor of claim 1 or 2, wherein the first impurity region and the second impurity region contain dopants of a same conductivity type.

4. The transistor of claim 1, 2, or 3, wherein a number of source/drain contacts of the first source/drain contact group is equal to a number of source/drain contacts of the second source/drain contact group.

5. The transistor of any one of claims 1 to 4, wherein a spacing between the first impurity region and an upper surface of the substrate is different from a spacing between the second impurity region and the upper surface of the substrate.

6. The transistor of any one of claims 1 to 5, wherein a spacing between the first impurity region and an upper surface of the substrate is equal to a spacing between the second impurity region and the upper surface of the substrate.

7. The transistor of any one of claims 1 to 6, wherein each of the first impurity region and the second impurity region contains a P-type dopant.

8. The transistor of any one of claims 1 to 7, wherein the source/drain area includes:
a third impurity region in contact with the first source/drain contact group; and
a fourth impurity region between the third impurity region and the gate electrode,
wherein a concentration of N-type impurities in the third impurity region is greater than a concentration of N-type impurities in the fourth impurity region.

9. The transistor of claim 8, wherein the first source/drain contact group includes a plurality of first source/drain contacts,
wherein the third impurity region includes a plurality of sub-impurity regions respectively overlapping the plurality of first source/drain contacts in a third direction that is perpendicular to an upper surface of the substrate.

10. The transistor of any one of claims 1 to 9, further comprising a third source/drain contact group on the source/drain area and spaced apart from the second source/drain contact group in the first direction,
wherein a spacing in the first direction between the first source/drain contact group and the second source/drain contact group is equal to a spacing in the first direction between the second source/drain contact group and the third source/drain contact group.

11. The transistor of any one of claims 1 to 10, wherein the second impurity region extends in a second direction intersecting the first direction.

12. The transistor of any one of claims 1 to 11,wherein the second impurity region does not overlap with the first source/drain contact group in a third direction perpendicular to an upper surface of the substrate.

13. The transistor of any one of claims 1 to 12, wherein the second impurity region does not overlap with the first source/drain contact group in the first direction.

14. The transistor of any one of claims 1 to 13, wherein the substrate surrounds the second impurity region in a plan view of the transistor.
